# EUROPEAN PATENT SPECIFICATION

(11) **EP 1 291 662 B1**
(45) Date of publication and mention of the grant of the patent: **21.12.2005**
(21) Application number: 02010951.8
(22) Date of filing: 16.05.2002
(51) Int. Cl.: G01R 31/3185

(54) **Debugging system for semiconductor integrated circuit**
Fehlersuchsystem für Halbleiter-integrierte Schaltung
Système de débogage pour circuit intégré à semi-conducteur

(30) Priority: 18.05.2001 JP 2001149977; 06.03.2002 JP 2002059998
(43) Date of publication of application: 12.03.2003
(73) Proprietor: Sony Computer Entertainment Inc., Tokyo 107-0052 (JP)
(72) Inventor: Sugawara, Akihiko, Sony Computer Entertainment Inc, Tokyo 107-0052 (JP)
(74) Representative: Müller - Hoffmann & Partner

(56) References cited:
- EP-A- 0 073 602
- CA-A- 1 197 322
- US-A- 4 710 932
- US-A- 5 907 671

## Description

This application is related to Japanese Patent Application No. 2001-149977 filed on May 18, 2001 and No. 2002-059998 filed on March 6, 2002.

### BACKGROUND OF THE INVENTION

### 1. Field of the Invention

The present invention is related to a debugging system for analyzing internal signals of LSIs and debugging (fixing defects or errors) hardware or software within the LSIs, a semiconductor integrated circuit, a debugging method thereof, a debugging program for the semiconductor integrated circuit, and a computer-readable recording medium having recorded therein the debugging program for the semiconductor integrated circuit.

### 2. Description of the Related Art

In general, debugging processing of hardware and software within LSI (LSI: Large Scale Integration) is performed by observing and analyzing internal signals of the LSI with utilizing a measuring device such as a logic analyzer or oscilloscope. It is thus important to observe and analyze internal signals as many as possible through the debugging processing in order to design and manufacture the LSI having no defects or errors.

However in the case that output terminals of the LSI are added to observe the internal signals as many as possible, the LSI may have complicated configuration and large dimension, and further may become expensive.

To overcome such problems, it can be considered that internal signals output from output terminals are switched every period of time, whereupon a plurality of internal signals cannot be observed at the same time, so that correlation between internal signals is not analyzable, resulting in that debugging of the entire LSI is not accurately performed.

Further information pertaining to the prior art can be found in CA 1 197 322 which teaches an apparatus for the dynamic in-circuit testing of digital electronic devices employs a hardware testing circuit that is set by a microcomputer which takes no direct part in the test, so that the test hardware speed is not limited by the computer speed. The apparatus comprises a library of devices corresponding to the devices to be tested, the library including a ROM containing the information regarding the devices needed by the microcomputer for its purpose. An internal interface or router receives signals from the test device that are input signals to its terminals and routes them directly to the corresponding selected device in the library where it becomes an input to that device also. Signals from the test device that are output signals are routed instead to a comparison block where they are compared with the respective output signals from the library reference device. The signals at each corresponding pin of the two devices are compared and upon the presence of a fault the apparatus stops and identifies the pin or pins on which a fault has been detected.

EP 0 073 602 teaches a system comprising replicated sub-systems the outputs of which are consolidated to provide a single output by a majority voter for reliability and availability. The integrity of the system, i.e. confidence in the single consolidated output, is provided by an electronic coincidence checking arrangement that involves several levels of checking. A first level of checking is carried out on all sub-system outputs by circuits in each sub-system channel. Thus, each channel assesses the other channels and itself for coincidence. These assessments are then consolidated in respect of each sub-system at a second level and the final result employed as an inhibit or power supply disabling control if a fault is declared in one sub-system.

US patent 4,710,932 teaches a fault detection system for electronic circuits that comprises a detection circuit in which the cross-correlation values between the test signal sequence, input to a circuit to be tested, and the output signal sequence from it, with no delay and with delays made in steps to a predetermined time interval either in the test input signal or in the output sequence, are counted, a reference circuit in which the cross-correlation values between the test signal sequence input to a faultless reference circuit and the output signal sequence from it, are counted, and a comparator for comparing the cross-correlation values from both the detection and reference circuit.

US patent 5,907,671 teaches a fault tolerant circuit having improved error correction and detection properties that takes advantage of two distinct forms of information redundancy: modular redundancy and parity check bit redundancy, in a cooperative fashion. In particular, it is shown that simple majority voting logic circuits, when employed in the subject environment, provide an easily realized mechanism for error correction and error detection. This results in an extremely fault tolerant information system.

### SUMMARY OF THE INVENTION

Accordingly, in consideration of the above-noted problems, it is an object of the present invention to provide a debugging system, a semiconductor integrated circuit, a debugging method thereof, a computer program product, in the following also referred to as a debugging program for the semiconductor integrated circuit, and a computer-readable recording medium having recorded therein the debugging program for the semiconductor integrated circuit, all of which are capable of readily debugging the entire LSI in low-cost and simple configuration.

The debugging system according to the present invention is defined in independent claim 1, the semiconductor integrated circuit according to the present invention is defined in independent claim 5, and the debugging method according to the present invention is defined in independent claim 7. Preferred embodiments thereof are respectively defined in the respective following subclaims. The computer program product according to the present invention is defined in claim 9 and the computer-readable recording medium according to the present invention is defined in claim 10.

In the present invention, applied are a plurality of semiconductor integrated circuits having the same configuration as that of a semiconductor integrated circuit which is subjected to debugging, wherewith different internal signals are respectively collected from those semiconductor integrated circuits under the same operation condition, in which internal signals proportional to the number of connected semiconductor integrated circuits are collected, and operation of the semiconductor integrated circuit is analyzed based on the collected internal signals.

According to this configuration, it is not necessary to add output terminals of the semiconductor integrated circuit or switch internal signals output from the output terminals every period of time, thereby enabling the debugging of the entire semiconductor integrated circuit without an increase in its cost.

It is alternatively possible that, three or more semiconductor integrated circuits are connected, in which internal signals that are all different are collected from the respective semiconductor integrated circuits while being two or more of those being under the same operation condition.

It is alternatively possible that, three or more semiconductor integrated circuits are connected under the same operation condition, internal signals that are all different being collected from two or more of those connected semiconductor integrated circuits.

It is still possible that, three or more semiconductor integrated circuits are connected, in which operation condition of one of those is monitored, and internal signals that are all different are collected from two or more semiconductor integrated circuits so that operation condition of semiconductor integrated circuits other than the semiconductor integrated circuit being monitored is under the same operation condition as that of the semiconductor integrated circuit being monitored.

Other and further objects and features of the present invention will become obvious upon understanding of the illustrative embodiments about to be described in connection with the accompanying drawings or will be indicated in the appended claims, and various advantages not refereed to herein will occur to one skilled in the art upon employing of the invention in practice.

### BRIEF DESCRIPTION OF DRAWINGS

FIG. 1 is a schematic diagram showing the entire configuration of a debugging system according to an embodiment of the present invention;
FIG. 2 is a schematic diagram showing an appearance of LSI within the debugging system in FIG. 1;
FIG. 3 is a schematic diagram showing the internal configuration of the LSI in FIG. 2; and
FIG. 4 is a flowchart showing operation of the debugging system.

### DETAILED DESCRIPTION OF THE PREFERRED EMBODIMENTS

Various embodiments of the present invention will be described with reference to the accompanying drawings. It is to be noted that the same or similar reference numerals are applied to the same or similar parts and elements throughout the drawings, and the description of the same or similar parts and elements will be omitted or simplified.

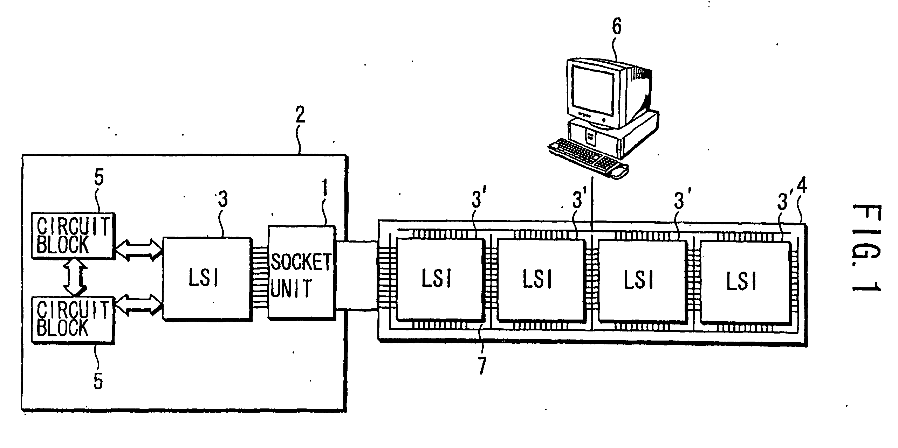

The present invention can be applied to a debugging system, which observes and analyzes internal signals of LSI as shown in FIG. 1.

### Configuration of Debugging System

The entire configuration of the debugging system according to an embodiment of the present invention is described with reference to FIG. 1.

As shown in FIG. 1, the debugging system of the embodiment is configured so that a debugging dedicated board **4** is electrically connected via a socket unit **1** to LSI **3** within a board **2** which is subjected to debugging. The LSI **3** is also connected to other circuit blocks **5** in the board **2.**

The debugging dedicated board **4** is connected to a computer system **6** via electric wirings, and is provided therein with a plurality of LSIs **3**' (hereinafter, referred to as debug LSIs, for the purpose of distinguishing with LSI **3**) which have the same configuration as that of the LSI 3. Output terminals of the LSI **3** and those of the debug LSIs **3**' are mutually connected with corresponding terminals through an electric wiring **7**.

It is to be understood that, in this embodiment, the debugging dedicated board **4** is provided therein with four debug LSIs, however, the present invention is not limited to this number, where it is alternatively possible to add or remove the debug LSI in accordance with the number of internal signals to be observed.

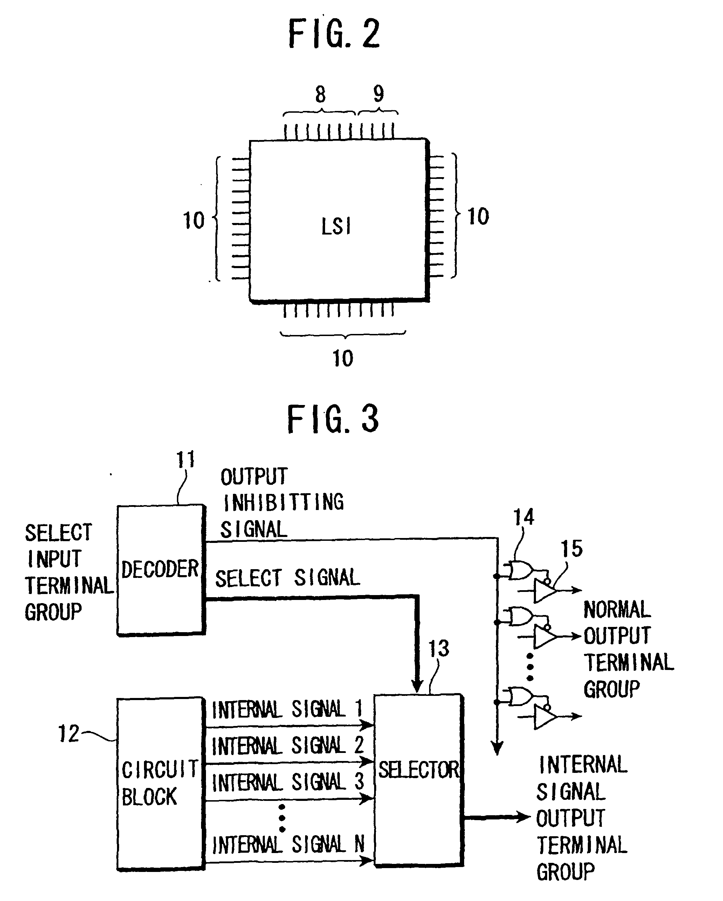

Next, configuration of the LSI **3** (=debug LSI) is described with reference being made to FIGS. 2 and 3.

As shown in FIG. 2, the LSI **3** has a plurality of internal signal output terminals **8,** a plurality of selector terminals **9,** and a plurality of normal output terminals **10**. And, the normal output terminals **10** are connected with those of the debug LSI via a socket unit 1.

Within the LSI **3,** provided are a decoder **11,** a selector **13,** AND circuits **14** and buffer circuits **15** other than a circuit block **12** for realizing various functions of LSI, as shown in FIG. 3.

The normal output terminals **10** perform normal operation (output internal signals) only when a pattern of the signal input into the selector terminals **9** is a specific one, and in the case of patterns other than the specific one, the normal output terminals **10** are inhibited from outputting internal signals.

### Operation of Debugging System

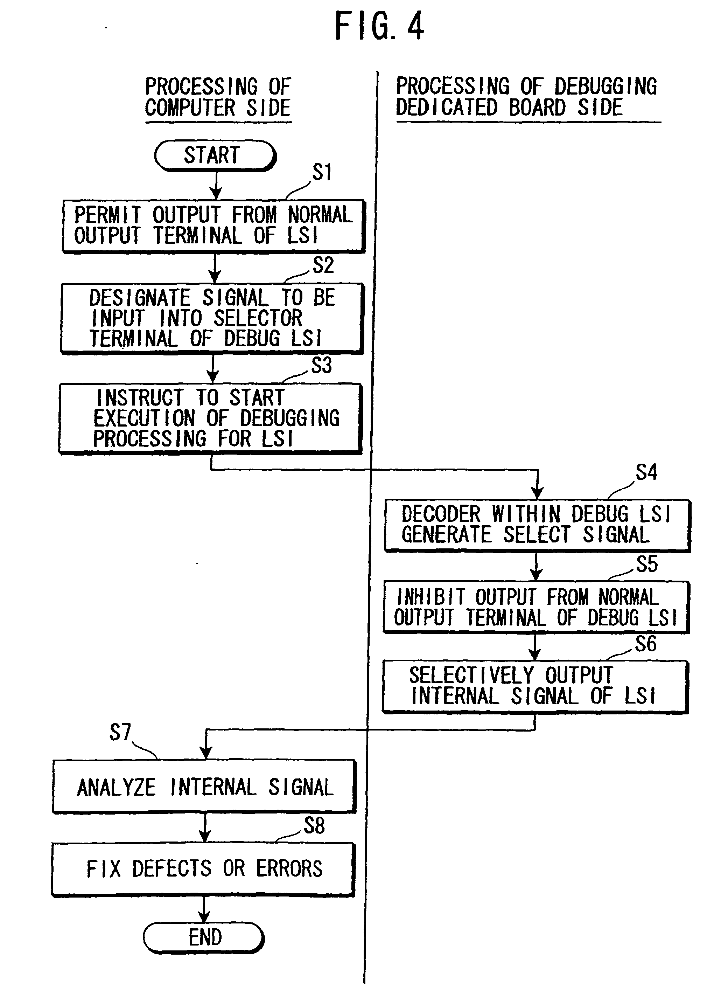

A debugging processing of the LSI **3,** which utilizes the above-mentioned debugging system, is described referring to FIG. 4.

The processing shown in the flowchart of FIG. 4 starts with connecting the LSI **3** with the debugging dedicated board **4** via the socket unit **1** by a debugging processing executor (hereinafter, referred to as an operator), at which point the debugging processing proceeds to step **S1**.

In step **S1**, the operator inputs into the selector terminals **9** of the LSI **3** directly or through the computer system **6** a signal pattern which indicates to permit the normal output terminals **10** to output.

This allows the LSI **3** to perform normal operation, and internal signals are output from the normal output terminals of the LSI **3.** This completes the processing of step **S1**, whereupon the debugging processing proceeds from step **S1** to step **S2.**

In step **S2**, the operator designates signal patterns, for example, high level/low level, to be input into the selector terminals **9** of the respective debug LSIs by operating the computer system **6**.

More specifically, the operator designates signal patterns that are all different for each debug LSI. For example, when the operator inputs a signal pattern of high level/low level into one debug LSI, the operator inputs a different signal pattern of low level/high level into another debug LSI. By doing this, internal signals that are all different for each debug LSI are output from the internal signal output terminals of the respective debug LSIs.

It is noted here that the operator does not designate to the selector terminals **9** of the debug LSIs the signal patterns (in the above exemplary case, high level/high level for example) which indicates to permit the normal output terminals **10** to output.

By doing this, from the normal output terminals **10** of the debug LSIs, internal signals are not output, however, from the normal output terminals **10** of the LSI **3,** internal signals are output to be transmitted to the corresponding normal output terminals **10** of the debug LSIs, so that the debug LSIs apparently perform normal operation. This completes the processing of step **S2,** whereupon the debugging processing proceeds from step **S2** to step **S3.**

In step **S3,** the operator instructs to execute the debugging processing of the LSI **3.** Upon such instruction, the computer system **6** outputs to the selector terminals **9** of the debug LSIs the signal patterns designated by the operator in step **S2.** This completes the processing of step **S3,** at which point the debugging processing proceeds from step **S3** to step **S4**.

In step **S4,** the decoders **11** in the respective debug LSIs generate select signals to specify internal signals of the circuit block **12** for selectively outputting, in accordance with the signal patterns input into the selector terminals **9** of the debug LSIs by the computer system **6.** This completes the processing of step **S4,** at which point the debugging processing proceeds from step **S4** to step S5.

In step **S5,** the decoders **11** in the respective debug LSIs generate output inhibiting signals which inhibits output from the normal output terminals **10** of the debug LSIs, and then output the output inhibiting signals to the AND circuits **14.** This makes the normal output terminals **10** not to output the internal signal of the circuit block **12,** at which point the debugging processing proceeds from step **S5** to step **S6.**

In step **S6,** the selectors **13** in the respective debug LSIs select and output the internal signals of the circuit block **12** to the internal signal output terminals **8,** in accordance with the select signals generated by the decoders **11.** Furthermore, in response to the output inhibiting signals generated by the decoder **11,** the AND circuit **14** operates a buffer circuit **15** controlling output from the normal output terminals **10** so as to inhibit output from the normal output terminals **10**. This completes the processing of step **S6,** whereupon the debugging processing proceeds from step **S6** to step **S7.**

In step **S7,** the operator observes the internal signals output from the internal signal output terminals **8** of the respective debug LSIs with using the computer system **6,** and analyzes problems or errors (bug) existing in hardware or software of the LSI **3** by utilizing tools such as timing analysis program. This completes the processing of step **S7**, whereupon the debugging processing proceeds from step **S7** to step **S8.**

In step **S8,** on the basis of the analysis result, the operator fixes the defects or errors within hardware or software of the LSI **3.** This completes a series of the debugging processing.

As is clear from the foregoing detailed description, in the debugging system according to the embodiment, since internal signals are collected from a plurality of debug LSIs which are all connected to the LSI **3,** it is not necessary to add output terminals of the LSI **3** only for collecting the internal signals, nor is it necessary to switch the internal signals output from output terminals every period of time. This facilitates the debugging of the entire LSI in low-cost and simple configuration.

Further, in the debugging system of the embodiment, internal signals that are all different from each other can be collected at the same time from the debug LSIs which are under the same operation condition as that of the LSI **3**, thereby allowing the operator to observe correlation between the internal signals and to execute the debugging processing of the entire LSI with high accuracy.

### Other Embodiments

The foregoing is a description of preferred embodiments of the present invention made by the inventors, and it will be understood that the foregoing description and drawings, which is a partial description of embodiments, do not restrict the present invention. It is therefore to be understood that the present invention may be practiced in any modifications depending on the design or the like otherwise than as specifically described herein without departing from the claimed scope thereof.

For example, although in the foregoing description, processing from step **S1** to step **S8** are executed in order, it will be understood that processes from step **S3** to step **S5** are executed substantially at the same time. Out of processing of step **S1** to step **S8,** in particular, in the case where processing of step **S1** and step **S2** are executed in order, signals are output at the same time from the plurality of LSIs if the operator gives at a wrong timing signals to the LSI, thereby causing troubles such that damaging the LSIs. Accordingly, it is desirable to execute the processing of step **S1** and step **S2** simultaneously in order to prevent occurrence of such troubles.

According to the foregoing embodiment, although the debugging processing is performed by connecting the debugging dedicated board **4** and the computer system **6** with each other, it is alternatively possible to perform the processing by connecting general-purpose measuring devices such as a logic analyzer and the like in place of the computer system **6** to the debugging dedicated board 4.

With the foregoing embodiment, by inputting select signals through a plurality of selector terminals, internal signals which are all different are output from a plurality of semiconductor integrated circuits under the same operation condition. However, it will be understood that this is not a restriction. For example, it is preferable that, such as a serial input of select information while using fewer selector terminals, a plurality of semiconductor integrated circuits are controllable so as to output internal signals that are all different for every semiconductor integrated circuit.

The operation of the above-described debugging system can be stored as a program in a storage medium from which it can be read into a computer. When executing the debugging processing, the storage medium is read into the computer system, and the program is stored in a storage section such as a memory within the computer system. And then, an operation unit executes the program so as to achieve the operation of the above-noted debugging processing.

The term storage medium used in this case refers to a computer readable storage medium in which program can be stored of, such as semiconductor memory, a magnetic disk, an optical disk, a magneto-optic disk, or a magnetic tape or the like.

## Claims

1. A debugging system comprising:
a board (4) used for debugging, having a plurality of semiconductor integrated circuits (3') which have the same configuration ; and
analyzing means (6) for collecting different internal signals from the respective semiconductor integrated circuits within the board while those being under the same operation condition, and analyzing operation of said semiconductor integrated circuits based on the collected internal signals.

2. The debugging system according to Claim 1, wherein each of the semiconductor integrated circuits has selective output terminals (8) for selectively outputting internal signals of the respective semiconductor integrated circuit in accordance with a respective signal pattern input by the analyzing means.

3. The debugging system according Claim 2, wherein output terminals (10) of the respective semiconductor integrated circuits other than the selective output terminals output internal signals only when a predetermined signal pattern is input by the analysing means.

4. The debugging system according to Claim 3, wherein the output terminals of the respective semiconductor integrated circuits are connected to corresponding output terminals (10) of other semiconductor integrated circuits within the board, and the predetermined signal pattern is input into at least one of the plurality of semiconductor integrated circuits.

5. The debugging system according to claim 1, wherein each of said semiconductor integrated circuits (3, 3') comprises:
a plurality of selector terminals (9) for inputting signal patterns to specify internal signals to be collected;
a plurality of internal signal output terminals (8) for selectively outputting internal signals in accordance with the signal patterns input into the selector terminals; and
a plurality of normal output terminals (10) for outputting internal signals only when a predetermined signal pattern is input into the selector terminals.

6. The debugging system according to claim 5, wherein each of said semiconductor integrated circuits further comprises:
a decoder (11) for decoding the signal patterns input into the selectorterminals, and generating selector signals to specify the internal signals to be output from the internal signal output terminals; and
a selector (13) for selecting the internal signals to be output from the internal signal output terminals in accordance with the selector signals.

7. A debugging method of a semiconductor integrated circuit (3,3'), comprising the steps of:
inputting (S2) signal patterns to specify internal signals to be collected into a plurality of semiconductor integrated circuits (3') within a board (4) used for debugging, which have the same configuration
collecting (S6) the internal signals in response to the signal patterns from predetermined output terminals (8) of the respective semiconductor integrated circuits within the board while those being under the same operation condition; and
analyzing (S7) operation of the semiconductor integrated circuits based on the collected internal signals.

8. The debugging method of a semiconductor integrated circuit according to claim 7, comprising the steps of:
connecting output terminals (10) of the respective semiconductor integrated circuits other than the predetermined output terminals with corresponding output terminals (10) of other semiconductor integrated circuits; and
inhibiting (S5) at least one of the plurality of semiconductor integrated circuits from outputting internal signals from the output terminals other than the predetermined output terminals.

9. A computer program product comprising computer program means adapted to perform the method steps as defined in claim 7 or 8 when being executed on a computer.

## Patentansprüche

1. Fehlersuchsystem mit:
einer Baugruppe (4) für die Fehlersuche mit einer Mehrzahl von integrierten Halbleiterschaltungen (3'), die denselben Aufbau besitzen: und
Analysiermitteln (6) zum Sammeln verschiedener interner Signale von den entsprechenden integrierten Halbleiterschaltungen innerhalb der Baugruppe, während diese dieselbe Betriebsbedingung besitzen, und zum Analysieren der Tätigkeit der integrierten Halbleiterschaltungen auf der Basis der gesammelten internen Signale.

2. Fehlersuchsystem nach Anspruch 1, wobei jede der integrierten Halbleiterschaltungen ausgewählte Ausgangsanschlüsse (8) zum ausgewählten Ausgeben von internen Signalen der entsprechenden integrierten Halbleiterschaltung gemäß einem entsprechenden Signalmuster, das durch die Analysiermittel eingegeben wird, aufweist.

3. Fehlersuchsystem nach Anspruch 2, wobei die nicht ausgewählten Ausgangsanschlüsse (10) der entsprechenden integrierten Halbleiterschaltungen interne Signale lediglich dann ausgeben, wenn durch die Analysiermittel ein vorbestimmtes Signalmuster eingegeben wird.

4. Fehlersuchsystem nach Anspruch 3, wobei die Ausgangsanschlüsse der entsprechenden integrierten Halbleiterschaltungen mit entsprechenden Ausgangsanschlüssen (10) anderer integrierter Halbleiterschaltungen innerhalb der Baugruppe verbunden sind und das vorbestimmte Signalmuster in wenigstens eine aus der Mehrzahl von integrierten Halbleiterschaltungen eingegeben wird.

5. Fehlersuchsystem nach Anspruch 1, wobei jede der integrierten Halbleiterschaltungen (3, 3') aufweist:
eine Mehrzahl von Auswahlanschlüssen (9) zum Eingeben von Signalmustern, um die internen Signale, die gesammelt werden sollen, zu spezifizieren;
eine Mehrzahl von internen Signalausgabeanschlüssen (8) zum selektiven Ausgeben interner Signale gemäß den Signalmustern, die in die Auswahlanschlüsse eingegeben werden; und
eine Mehrzahl von normalen Ausgangsanschlüssen (10) zum Ausgeben interner Signale lediglich dann, wenn ein vorbestimmtes Signalmuster in die Auswahlanschlüsse eingegeben wird.

6. Fehlersuchsystem nach Anspruch 5, wobei jede der integrierten Halbleiterschaltungen außerdem aufweist:
eine Entschlüsselungseinrichtung (11) zum Entschlüsseln der Signalmuster, die in die Auswahlanschlüsse eingegeben werden, und zum Erzeugen von Auswahlsignalen, um die internen Signale, die von den internen Signalausgabeanschlüssen ausgegeben werden sollen, zu spezifizieren; und
eine Auswahleinrichtung (13) zum Auswählen der internen Signale, die von den internen Signalausgabeanschlüssen gemäß dem Auswahlsignal ausgegeben werden sollen.

7. Fehlersuchverfahren einer integrierten Halbleiterschaltung (3, 3') mit folgenden Schritten:
Eingeben (S2) von Signalmustern, um interne Signale, die in einer Mehrzahl von integrierten Halbleiterschaltungen (3'), die denselben Aufbau besitzen, innerhalb einer Baugruppe (4), die zur Fehlersuche verwendet wird, gesammelt werden sollen, zu spezifizieren;
Sammeln (S6) der internen Signale als Reaktion auf die Signalmuster von den vorbestimmten Ausgangsanschlüssen (8) der entsprechenden integrierten Halbleiterschaltungen innerhalb der Baugruppe, während diese dieselbe Betriebsbedingung besitzen; und
Analysieren (S7) der Tätigkeit der integrierten Halbleiterschaltungen auf Basis der gesammelten internen Signale.

8. Fehlersuchverfahren einer integrierten Halbleiterschaltung nach Anspruch 7 mit folgenden Schritten:
Verbinden von nicht vorbestimmten Ausgangsanschlüssen (10) der entsprechenden integrierten Halbleiterschaltungen mit entsprechenden Ausgangsanschlüssen (10) anderer integrierter Halbleiterschaltungen; und
Verhindern (S5) des Ausgebens von internen Signalen an den nicht vorbestimmten Ausgangsanschlüssen bei wenigstens einer aus der Mehrzahl von integrierten Halbleiterschaltungen.

9. Computerprogrammprodukt mit einem Computerprogrammmittel, das darauf ausgerichtet ist, die Verfahrensschritte gemäß Anspruch 7 oder 8 durchzuführen, wenn das Computerprogrammmittel auf einem Computer ausgeführt wird.

## Revendications

1. Système de débogage comprenant :
une carte (4) qui est utilisée pour déboguer, comportant une pluralité de circuits intégrés à semiconducteur (3') qui présentent la même configuration ; et
un moyen d'analyse (6) pour collecter différents signaux internes à partir des circuits intégrés à semiconducteur respectifs à l'intérieur de la carte tandis que ceux-ci sont sous la même condition de fonctionnement et pour analyser un fonctionnement desdits circuits intégrés à semiconducteur sur la base des signaux internes collectés.

2. Système de débogage selon la revendication 1, dans lequel chacun des circuits intégrés à semiconducteur comporte des bornes de sortie sélectives (8) pour émettre en sortie de façon sélective des signaux internes du circuit intégré à semiconducteur respectif conformément à un motif de signal respectif qui est entré par le moyen d'analyse.

3. Système de débogage selon la revendication 2, dans lequel les bornes de sortie (10) des circuits intégrés à semiconducteur respectifs autres que les bornes de sortie sélectives émettent en sortie des signaux internes seulement lorsqu'un motif de signal prédéterminé est entré par le moyen d'analyse.

4. Système de débogage selon la revendication 3, dans lequel les bornes de sortie des circuits intégrés à semiconducteur respectifs sont connectées à des bornes de sortie correspondantes (10) d'autres circuits intégrés à semiconducteur à l'intérieur de la carte, et le motif de signal prédéterminé est entré dans au moins l'un de la pluralité de circuits intégrés à semiconducteur.

5. Système de débogage selon la revendication 1, dans lequel chacun desdits circuits intégrés à semiconducteur (3, 3') comprend :
une pluralité de bornes de sélecteur (9) pour entrer des motifs de signal afin de spécifier des signaux internes à collecter ;
une pluralité de bornes de sortie de signal interne (8) pour émettre en sortie de façon sélective des signaux internes conformément aux motifs de signal qui sont entrés dans les bornes de sélecteur ; et
une pluralité de bornes de sortie normales (10) pour émettre en sortie des signaux internes seulement lorsqu'un motif de signal prédéterminé est entré dans les bornes de sélecteur.

6. Système de débogage selon la revendication 5, dans lequel chacun desdits circuits intégrés à semiconducteur comprend en outre :
un décodeur (11) pour décoder les motifs de signal qui sont entrés dans les bornes de sélecteur et pour générer des signaux de sélecteur afin de spécifier les signaux internes destinés à être émis en sortie depuis les bornes de sortie de signal interne ; et
un sélecteur (13) pour sélectionner les signaux internes à émettre en sortie depuis les bornes de sortie de signal interne conformément aux signaux de sélecteur.

7. Procédé de débogage d'un circuit intégré à semiconducteur (3, 3'), comprenant les étapes de :
entrée (S2) de motifs de signal afin de spécifier des signaux internes à collecter dans une pluralité de circuits intégrés à semiconducteur (3') à l'intérieur d'une carte (4) qui est utilisée pour déboguer, lesquels circuits présentent la même configuration ;
collecte (S6) des signaux internes en réponse aux motifs de signal en provenance de bornes de sortie prédéterminées (8) des circuits intégrés à semiconducteur respectifs à l'intérieur de la carte tandis que ceux-ci sont sous la même condition de fonctionnement ; et
analyse (S7) d'un fonctionnement des circuits intégrés à semiconducteur sur la base des signaux internes collectés.

8. Procédé de débogage d'un circuit intégré à semiconducteur selon la revendication 7, comprenant les étapes de :
connexion de bornes de sortie (10) des circuits intégrés à semiconducteur respectifs autres que les bornes de sortie prédéterminées avec des bornes de sortie correspondantes (10) d'autres circuits intégrés à semiconducteur ; et
inhibition (S5) d'au moins l'un de la pluralité de circuits intégrés à semiconducteur pour l'empêcher d'émettre en sortie des signaux internes depuis les bornes de sortie autres que les bornes de sortie prédéterminées.

9. Produit de programme d'ordinateur comprenant un moyen de programme d'ordinateur adapté pour réaliser les étapes du procédé tel que défini selon la revendication 7 ou 8 lorsqu'il est exécuté sur un ordinateur.
